(19) Europäisches Patentamt
European Patent Office
Office européen des brevets

(11) Publication number: **0 464 751 A2**

# (12) EUROPEAN PATENT APPLICATION

(21) Application number: **91110887.6**

(51) Int. Cl.⁵: **H01L 27/02**

(22) Date of filing: **01.07.91**

(30) Priority: **06.07.90 JP 177473/90**
**31.08.90 JP 228069/90**

(43) Date of publication of application:
**08.01.92 Bulletin 92/02**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken Tokyo(JP)**

(72) Inventor: **Nogami, Kazutaka**
**3-12-23-221, Ooyata, Adachi-ku**
**Tokyo(JP)**
Inventor: **Iizuka, Tetsuya**
**3-10-15, Matsugaoka**
**Funabashi-shi, Chiba-ken(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

## (54) Semiconductor device with protection circuit.

(57) In a semiconductor device having a plurality of circuits (22,23), a power pad (27,29) and a ground pad (28,30) are provided to each of said circuits. Each power pad (27,29) in different circuits is connected to each other through a resistor element (31) or a protection circuit, and each ground pad (28,30) in different circuits is connected to each other through another resistor element (31) or a protection circuit. Because of these connections, said circuits have a high resistivity against electrostatic destruction. Also, said circuits are not affected detrimentally by noise transmitted through said connections, because of the noise reduction caused by RC-coupled delay occured in said resistor elements, or because of the work of said protection circuit.

FIG.3

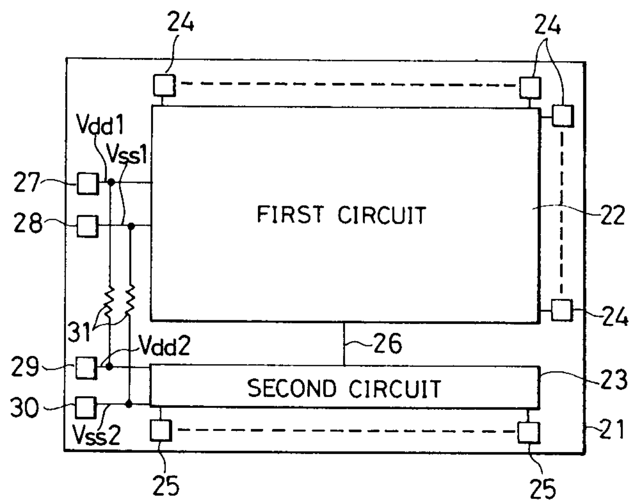




Rank Xerox (UK) Business Services

## BACKGROUND OF THE INVENTION

### Field of the invention

This invention relates to a semiconductor device having a plurality of circuits. More particulary it relates to a semiconductor device in which a plurality of pins ( which correspond to pads on a semiconductor chip ) are provided to each circuit in order to supply a power voltage, ground voltage, etc. to each circuit.

### Description of the Prior Arts

In a prior art semiconductor device having a plurality of power pins and ground pins, for example, in an LSI ( large scaled integrated circuit ) device, power pads and ground pads are connected in common for each other with metal wiring layers, so as to protect inner circuits from being destroyed by electrostatic discharge. In other prior art semiconductor devices, the power pad and ground pad provided to a noise generative circuit, ( e.g., an output circuit ), are separated from those provided to a different circuit. All the prior art semiconductor devices having a plurality of power pins and ground pins should be classified into either of the above mentioned two structures.

Fig. 1a shows a structure of a semiconductor chip in which said plurality of power pads and ground pads are connected to each other by metal wiring layers. In the figure, a first circuit 2, which is detrimentally affected by noise, and a second circuit 3, which is noise generative, are made together on a semiconductor chip 1. The first and second circuits 2 and 3 are provided with singal pads 4 and 5. Signal line 6 is provided to connect circuits 2 and 3. The first circuit 2 is provided with a power pad 7 and a ground pad 8. The second circuit 3 is also provided with a power pad 9 and a ground pad 10. Although not shown in the figure, a pin is connected to each pad so as to compose input and output terminals of the semiconductor device. In the figure, power pads 7 and 9 in the first circuit 2 and the second circuit 3 are connected by a metal wiring layer 11, and ground pads 8 and 10 in the first and second circuit are connected by a metal wiring layer 12.

The semiconductor chip shown in Fig. 1b is arranged according to the same concept as that of the semiconductor chip shown in Fig. 1a. The semiconductor chip shown in Fig. 1b is, however, characterized by the fact that metal wiring layers 11 and 12 are connected to each other via a protection circuit 13.

In the devices shown in Figs. 1a and 1b, the power source and the ground source in chip 1 are connected in common by metal wiring layers 11 and 12. These sources are kept at Vdd and Vss respectively. As a result, an electrostatic high voltage applied for any pin, can be released by an input protection circuit ( not shown ) provided in each circuit and/or the protection circuit 13, so as to protect inner circuits from being destroyed by electrostatic discharge.

When circuit 3, ( e.g., an output circuit ), which generates noise in its power source and ground source, and circuit 2, ( e.g., an input circuit ), which is detrimentally affected by noise, are formed together within one chip, the noise produced in the power source or the ground source of circuit 3 is transmitted to circuit 2 to cause a malfunction. This is because the power sources and ground sources in both circuits are connected in common.

Fig. 2a shows a structure of a semiconductor chip, in which the power pad and the ground pad in the noise generative circuit 3 are separated electrically from those in the first circuit 2, which is detrimentally affected by noise, in order to prevent a malfunction caused by noise. As shown in the figure, the power sources and the ground sources of the circuits 2 and 3 are separated electrically from each other. Power pads 7 and 9 are kept at Vdd1 and Vdd2 voltages respectively while ground pads 8 and 10 are kept at Vss1 and Vss2 voltages respectively. In this device, then, the noise from the noise generative circuit 3 can not be transmitted to circuit 2. The malfunction caused by noise will not, therefore, occur in circuit 2.

On the other hand, a high voltage, applied between the power pad 9 or ground pad 10 of circuit 3 and signal pad 4 of circuit 2, can not be discharged by the input protection circuits provided in circuit 2 and circuit 3. This is because the power pads and ground pads of circuits 2 and 3 are not connected in common.

Thus, the high voltage, applied between pad 9 or 10 and signal pad 4, may be introduced directly into transistors in circuits 2 and 3 through signal line 6 so as to destroy these transistors. The same phenomenon will take place when a high voltage is applied between signal pad 5 of circuit 3 and pad 7 or 8 of circuit 2, and the transistors in circuits 2 and 3 will be destroyed.

The semiconductor device shown in Fig. 2b is arranged according to the same concept as that of the device shown in Fig. 2a. In this device, however, the protection circuits 13, 13 are provided to connect power pad 7 and ground pad 8 and between power pad 9 and ground pad 10, so as to deal with the high voltage applied between power pads and ground pads. In spite of the structure mentioned above, it is evident that the device shown in Fig. 2b has the same disadvatage as that of the device shown in Fig. 2a.

## SUMMARY OF THE INVENTION

This invention has been made to overcome the above mentioned disadvantages of the prior art semiconductor devices.

One object of this invention is, therefore, to provide a semiconductor device having a plurality of circuits, in which each circuit can be protected from being destroyed by electrostatic discharge as well as protected from a malfunction due to noise.

Another object of this invention is to provide a semiconductor device having a plurality of circuits, in which a means is provided to protect each circuit from being destroyed by electrostatic discharge, and in which a noise-generative circuit and a noise affected circuit, can be provided together on one chip.

The first aspect of the present invention provides a semiconductor device having a plurality of circuits, each circuit having at least an input protection circuit, a power pad, and a ground pad, wherein resistor elements are inserted between said power pads and between said ground pads of said different circuits.

According to the first aspect, an electrostatic high voltage applied, for example, between a singal pad of the first circuit and a power pad or a ground pad of the second circuit, can be discharged through the input protection circuit in the first circuit, because both of the power pads or both of the ground pads of first and second. circuits are connected together. Then, elements in the first and second circuits will not be destroyed by the strong electrostatic charges. On the other hand, the noise generated, for example, from the second circuit, will be reduced between the two power pads or between the two ground pads of the first and second circuits, to such a degree that the first circuit will not perform a malfunction due to noise. This noise reduction is caused by an RC-coupled delay produced by the resistor element and the capacity existing among the power source and the ground source of the first circuit. Therefore, the first circuit will not be affected by the noise generated in the second circuit, and will not perform a malfunction. As a result, a semiconductor device having a high resistivity to electrostatic destruction and malfunction due to noise, can be provided according to the present invention. Also, a noise-generative circuit and a circuit which is detrimentally affected by noise, can be integrated on one semiconductor chip according to the present invention.

The second aspect of the present invention provides a semiconductor device having a plurality of circuits, each circuit having an input protection circuit, a power pad, and a ground pad, wherein protection circuits are inserted between power pads and between ground pads of said different circuits, and also between a power pad and a ground pad of each circuit. The protection circuit is comprised of a transistor, such as a field transistor, which keeps an off-state under ordinary conditions, but becomes conductive when a very high voltage is applied.

The third aspect of the present invention provides a semiconductor device having a plurality of circuits, each circuit having an input protection circuit, a power pad, and a ground pad, wherein protection circuits are inserted between power pads of said different circuits, between ground pads of said different circuits, between a power pad and a ground pad of each circuit, and also between a power pad in one circuit and a ground pad in another circuit. The protection circuit is comprised of a transistor, such as a field transistor, which keeps an off-state under ordinary conditions, but becomes conductive under a very high voltage application.

According to the second and third aspects, a high voltage applied, for example, between signal pads of a circuit and a power pad or a ground pad of a different circuit, can be discharged through said protection circuits without destroying inner elements. A high voltage applied between any power pad and any ground pad are, also, discharged in the same way. Also, noise generated in a circuit cannot be transmitted to other circuits because of the work of the protection circuit. In other words, the protection circuit keeps an off-state for a small voltage, such as a noise voltage. As a result, a semiconductor device having a high resistivity for electrostatic destruction and noise can be obtained, according to the present invention. Also, a circuit from which noise is generated and a circuit which is detrimentally affected by noise, can be integrated together on one semicondutor chip.

These and other objects, features, and advantages of the present invention will be more apparent from the following description of preferred embodiments, taken in conjunction with the accompanying drawings.

## BRIEF DESCRIPTION OF THE DRAWINGS

Figs. 1a and 1b are schematic views showing structures of prior art semiconductor devices;

Figs. 2a and 2b are schematic views showing structures of other prior art semiconcuctor devices;

Fig. 3 is a schematic view showing the structure of a semiconductor device according to the first embodiment of the present invention;

Fig. 4 is a schematic view showing the structure of a semiconductor device according to the second embodiment of the present invention;

Fig. 5 is a schematic view showing the structure of a semiconductor device according to the third embodiment of the present invention;

Fig. 6 is a schematic view showing the structure of a semiconductor device according to the fourth embodiment of the present invention;

Fig. 7 is a schematic view showing the structure of a semiconductor device according to the fifth embodiment of the present invention;

Fig. 8 is a schematic view showing the structure of a semiconductor device according to the sixth embodiment of the present invention;

Fig. 9 is a schematic view showing the structure of a semiconductor device according to the seventh embodiment of the present invention; and

Fig. 10 is a schematic view showing the structure of a semiconductor device according to the eighth embodiment of the present invention.

## DETAILED DESCRIPTION OF THE PRESENT INVENTION

In Fig. 3, a schematic view of a semiconductor device is shown according to an embodiment of the present invention. As shown, a first circuit 22 which is detrimentally affected by noise and a second circuit 23 from which noise is generated, are provided together on a semiconductor chip 21. Numbers 24, 24, . . . show signal pads of circuit 22, and numbers 25, 25, . . . show signal pads of circuit 23. Also, number 26 shows a signal line between circuits 22 and 23. Circuit 22 is provided with a power pad 27 and a ground pad 28. Also, circuit 23 is provided with a power pad 29 and a ground pad 30. In this device, resistor elements 31, 31 are provided to connect the different power sources Vdd1 and Vdd2, and between the grounds Vss1 and Vss2 respectively.

The operation of the above mentioned device will be explained below.

First, the case in which noise is generated from the second circuit 23 will be considered. The noise generated from circuit 23 is transmitted to circuit 22 through resistor element 31. At this time, however, the noise is reduced by the RC-delay caused by the resistor element and a capacity, which is made from the power source and the ground of the first circuit 22. The magnitude of the capacity is about 100 pF, usually. The RC time constant, then, comes out a few hundred pico-sec. to a few nano-sec., when the magnitude of the resistor element is over 1 Ω . The noise is, thus, reduced to a degree by which circuit 22 will not perform a malfunction. In other words, resistor element 31 works like a noise filter between circuits 22 and 23 to prevent circuit 22 from being affected by noise produced in the circuit 23. The effect of the noise filter is determined by the magnitude of the resistor element.

Next, the case in which a high voltage, due to electrostatic charges, is applied between signal pads 24 of circuit 22 and power pad 29 or ground pad 30 of circuit 23 will be considered. In this case, the charges are released through the input protection circuit contained in circuit 22 and resistor element 31 to power pad 29 or gound pad 30. The high voltage cannot, therefore, be applied to transistors in circuit 22 or transistors in circuit 23 connected to circuit 22 through signal line 26. These transistors are, thus, protected from being destroyed by the electrostatic charges. In the case where a high voltage is applied between signal pads 25 of circuit 23 and power pad 27 or ground pad 28 of circuit 22, the high charge is also released through the input protection circuit contained in circuit 23 and resistor element 31 to power pad 27 or ground pad 28 so as to protect transistors in circuit 22 from being destroyed by electrostatic high charges. In order to carry out the discharge quickly, the magnitude of the resistor element should be less than 100 Ω .

Although said semiconductor device has a plurality of power pads and ground pads as mentioned above, it has a high resistivity to electrostatic destruction, as well as, the filter effect for noise. A circuit which is detrimentally affected by noise and a circuit from which noise is generated, can, thus, be integrated in one chip without causing any malfunction.

As explained above, the magnitude of the resistor element should be over 1 Ω and under 100Ω .

When the substrate bias of a semiconductor chip is kept at either the power potential or the ground potential, the resistor elements should not be used for both the power source and the ground source. This is because the pads connected to the substrate bias in circuits 22 and 23 are connected to each other through the substrate. It is, therefore, neccessary to insert a resistor element only between pads which are not kept at the substrate bias, if the substrate bias is kept at either the power or ground potential.

Fig. 4 shows the second embodiment of this invention. In this embodiment, first, second and third circuits 22, 23 and 40 are provided in one chip. Resistor elements 31, . . . , in this case, are connected between any commbination of the power pads 27, 29, and 40 of the first, second, and third circuits, as shown. The resistor elements are also connected between any commbination of ground pads 28, 30, and 42 of the first, second, and third circuits 22, 23, and 40. From this arrangement, high electrostatic voltages, applied between any commbination of the signal pads 24, 25, and 43 and the power or ground pads in the first, second, and third circuit, are released without destroying any inner transistors. The noise affection among the first, second and third circuits 22, 23 and 40 can also be reduced by the filter effect caused by the RC-delay. In this figure, number 43 shows a signal pad of the third circuit 40, number 44 shows a signal line between the second and third circuits , and number 45 shows a signal line between the first and third circuits respectively.

Fig. 5 shows a schematic structure of a semiconductor device according to the third embodiment of the present invention. As shown, metal wirings 11 and 12 are used to connect each power pad and between each ground pad of the first and second circuits, in the same way as that of the embodiments shown in Figs. 3 and 4. Also, each circuit 22 and 23 includes an input protection circuit according to the ordinary structure.

Unlike the prior art devices, however, this device is characterized by the fact that protection circuits 50 and 50 are inserted between wirings 11 and 12, ( i.e., power pads 27 and 29 ) and also between ground pads 28 and 30, respectively. Second, protection circuits 51 and 51 are inserted between the power source and the ground source of each circuit, ( i.e., between pad 27 and pad 28 and between pad 29 and pad 30 ).

Protection circuits 50 and 51 are comprised of a field transistor or other transistors which keep an off-state under ordinary conditions, but become conductive under a high voltage application.

The operation of the embodying device mentioned above will be explained below.

First, the case in which noise is produced from the second circuit 23 will be considered. In this instance, the noise produced from circuit 23 can not be transmitted to circuit 22 through power wiring 11 and ground wiring 12, because of the operation of protection circuit 50. In other words, the field transistor or other transistors which keep an off-state under ordinary conditions, ( and from which protection circuit 50 is composed ), keep an open state under ordinary conditions so that the noise cannot be transmitted. As a result, even if the first circuit 22 is detrimentally affected by noise, it cannot be influenced by noise generated from circuit 23 and will not perform any malfunction caused by the noise.

Next, the case in which a high electrostatic voltage is applied between signal pad 24 of the first circuit 22 and power pad 29 or ground pad 30 of the second circuit 23, will be considered. In this case, the electric charges are released through the input protection circuit in the first circuit 22 and the protection circuit 50 to power pad 29 or ground pad 30. Thus, the inner transistors in circuit 22 and the inner transistors in the second circuit 23 connected to the first circuit 22 through signal line 6, are not applied with a high voltage. Therefore, these transistors are protected from destruction by high voltage. In the same way, when a high electrostatic voltage is applied between signal pad 25 of the second circuit 23 and power pad 27 or ground pad 28 of the first circuit 22, the charges can be released through the input protection circuit contained in the second circuit 23 and the protection circuit 50 to power pad 27 or ground pad 28. The transistors in circuit 22 are, therefore, protected from being destroyed by the electrostatic high voltage. When a high voltage is applied between power pads 27 and 29, between ground pads 28 and 30, and between a power pad and a ground pad separated from the power pad ( i.e., between pads 27 and 30, and between pads 29 and 28 ), the electric charges are released through the protection circuits 50 and 51 so as not to apply the high voltage directly to the inner transistors of circuits 22 and 23. As a result, these transistors are protected from being destroyed.

As mentioned above, the device shown in Fig. 5 is not readily destroyed by electrostatic charges applied for power pins and ground pins. Also, the device can be provided with a circuit which is detrimentally affected by noise and a circuit which generates noise on one chip together, without producing any malfunction.

In Fig. 6, a semiconductor device according to the fourth embodiment of the present invention is shown schematically. In this embodiment, instead of protection circuits 50 and 50 in the third embodiment, resistor elements 31 and 31 are inserted between pads 27 and 29, and between pads 28 and 30.

The device according to this embodiment shows substantially the same advantages as those of the third embodiment shown in Fig. 5. Considering first the noise transmission, noise produced from the second circuit 23 is conducted to the first circuit 22 through resistor element 31. Usually, there is a capacity of about a few hundred pF or more in the power source and the ground source of the first circuit 22. The noise is then conducted to the first circuit 22 by reducing its magnitude according to the RC-delay produced by the capacity and the resistor element 31. When the magnitude of the resistor element is more than 1Ω , the time constant will be a few hundred pico-sec. to a few nano-sec., and therefore circuit 22 will not perform a malfunction due to noise. In other words, the resistor element 31 works like a noise filter between the first circuit 22 and the second circuit 23. The effect of this noise filter can be arranged by changing the magnitude of the resistor element so as not to conduct the noise between the first and the second circuits.

Next, the case in which an electrostatic high voltage is applied between signal pads 24 of the first circuit 22 and power pad 29 or ground pad 30 of the second circuit 23, will be considered. In this case, charges are released through the input protection circuit in the first circuit 22 and resistor element 31 into power pad 29 or ground pad 30. Therefore, inner transistors of the first circuit 22 and second circuit 23 connected to each other through signal line 26, cannot be applied with a high voltage. So, they are protected from destruction by high voltage. In the case where a high voltage is applied between signal pads 25 of the second circuit 23 and power pad 27 or ground pad 28 of the first circuit 22, the charges are released to power pad 27 or ground pad 28 through the input protection circuit in the second circuit 23 and resistor element 31, in the same way as that mentioned above. Therefore, the transistors in the first and second circuits 22 and 23 cannot be applied with a high voltage so as to be protected from destruction by high voltage. It is desirable to have the magnitude of resistor element 31 under 100Ω in order to carry out the charge release quickly.

In other cases in which a high voltage is applied between power pads 27 and 28, between ground pads 28 and 30, or between a power pad and a ground pad separated from each other ( i.e., between pads 27 and 30, and between pads 29 and 28 ), the charges can be released through protection circuit 51 and resistor element 31 without applying a high voltage directly to the inner transistors in circuits 22 and 23. These transistors can, thus, be protected from destruction by high voltage.

As mentioned above, the device according to this embodiment also has a high resistivity to the electrostatic destruction which occured in power and ground pads. At the same time, the device can be provided with a circuit from which noise is generated and a circuit which is detrimentally affected by noise, together on one chip without performing any malfunction due to noise. It should be noticed that the resistor element can be made with a smaller area than that of the protection circuit. Concequently, the decvice according to this embodiment has an advantage in that this can be made up of a smaller chip area than that of the device according to the third embodiment. The magnitude of the resistor element should be over 1 Ω and under 100Ω , as mentioned above.

In Fig. 7, a schematic structure of a semiconductor device according to the fifth embodiment of this invention, is shown. In this embodiment, protection circuits 52 and 52 are added between power and ground pads which are separated from each other, ( i.e., between pads 27 and 30 and between pads 28 and 29 ), unlike the device according to the third embodiment shown in Fig. 5.

When a high voltage is applied between a power pad in a circuit and a ground pad in a different circuit, ( e.g., between pad 27 and pad 30 and between pad 28 and pad 29, a discharge path can be formed through only protection circuit 52, in this device. The charges applied can, thus, be released faster in this device than in the device according to the third embodiment mentioned above. This device can, therefore, be said to have stronger resistance against electrostatic destruction than that of the device according to the third embodiment. In the third embodiment, the discharge path is formed through both protection circuits 50 and 51, in the same way as mentioned above.

In Fig. 8, a schematic view of a semiconductor device according to the sixth embodiment of this invention is shown. In addition to the protection circuits provided in the fourth embodiment, protection circuits 52 and 52 are also provided in this embodiment between power pads and separated ground pads, ( e.g., between pads 27 and 30, and between pads 28 and 29 ), in the same way as that of the fifth embodiment. The same advantages mentioned in the fifth embodiment are obtained by protection circuits 52 and 52 in this embodiment.

Fig. 9 shows a schematic structure of a semiconductor device according to the seventh embodiment of this invention. In this embodiment, the third circuit 60 is further provided with the first and the second circuits 22 and 23. All the pads in this device, including a power pad 61 and a ground pad 62 of the third circuit 60 are classified into three groups as shown in the figure. The protection circuits 50 and 51 are provided between any combination of a power pad and a ground pad in each classified group. In the figure, number 63 shows a signal pad of the third circuit 60. According to the structure mentioned above, a semiconductor device having a strong resistivity against electrostatic destruction and noise can also be obtained because of the same reason mentioned in the fifth embodiment.

Fig. 10 shows a schematic structure of a semiconductor device according to the eighth embodiment of this invention. This embodiment is a variation of the seventh embodiment mentioned above. In other words, resistor elements 31, . . . are used in this embodiment instead of protection circuits 50 in the seventh embodiment. According to this structure, a semiconductor device having a strong resistivity against electrostatic destruction and noise, can be obtained because of the same reason mentioned in the sixth embodiment.

As mentioned in the explanation of the prior arts, a pin is provided for each pad as a connection terminal to the outside of a semiconductor device.

## Claims

**1.** A semiconductor device, comprising:
a plurality of circuits, each circuit having an input protection circuit;
a plurality of pads provided to each of said circuit in order to supply a first voltage to each circuit; and
resistor elements provided to connect one pad in said circuits and another pad in said different circuits.

**2.** The semiconductor device as claimed in Claim 1, wherein said first voltage is a power voltage and said plurality of pads are power pads.

**3.** The semiconductor device as claimed in Claim 1, wherein said resistor elemnts are provided between any commbination of said plurality of pads.

**4.** A semiconductor device, comprising:
a plurality of circuits, each circuit having an input proteciton circuit;
a plurality of power pads provided to each of said circuits in order to supply a power voltage to each circuit;
a plurality of ground pads provided to each of said circuit in order to earth each circuit;
resister elements provided to connect said power pads in said different circuits; and
other resister elements provided to connect said ground pads in said different circuits.

**5.** The semiconductor device as claimed in Claim 1 or 4, wherein said resistor elements have the magnitude over 1 Ω and under 100Ω .

**6.** The semiconductor device as claimed in Claim 5, wherein said resistor elements are provided between any commbination of said power pads in said different circuits and also provided between any commbination of said ground pads in said different circuits.

**7.** A semiconductor device, comprising:
a plurality of circuits, each circuit having an input protection circuit;
a plurality of power pads provided to each of said circuits in order to supply a power voltage to each circuit;
a plurality of ground pads provided to each of said circuits in order to earth each circuit;
first protection circuits provided to connect said power pads in said different circuits, and to connect said ground pads in said different circuits; and
second protection circuits provided to connect said power pad and ground pad, both pads being provided in a same circuit.

**8.** A semiconductor device, comprising:
a plurality of circuits, each circuit having an input protection circuit;
a plurality of power pads provided to each of said circuit in order to supply a power voltage to each circuit;
a plurality of ground pads provided to each of said circuits in order to earth each circuit;
first protection circuits provided to connect said power pads in said different circuits and to connect said ground pads in said different circuits;
second protection circuits provided to connect said power pad and said ground pad in a same circuit; and
third protection circuits provided to connect said power pad in one circuit and a ground pad in a different circuit.

**9.** The semiconductor device as claimed in Claim 7 or 8, wherein said first protection circuits are comprised of resistor elements having the magnitude over 1 Ω and under 100Ω .

**10.** The semiconductor device as claimed in Claim 8, wherein each of said protection circuits is provided to connect any commbination of power pads and ground pads in said plurality of circuits.

FIG.1(a)

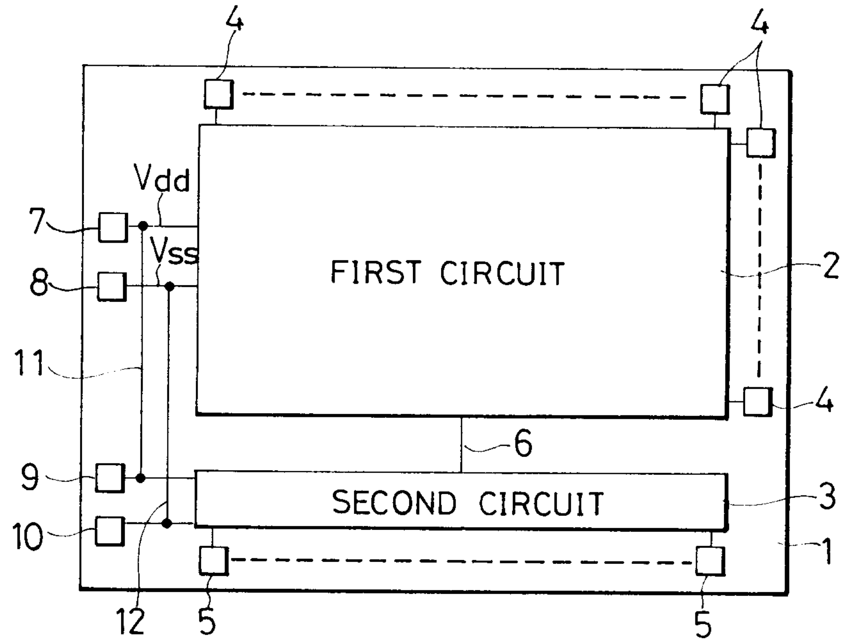
4
4
Vdd
7
Vss
FIRST CIRCUIT
2
8
11
4
6
9
SECOND CIRCUIT
3
10
1
12
5
5

FIG.2(a)

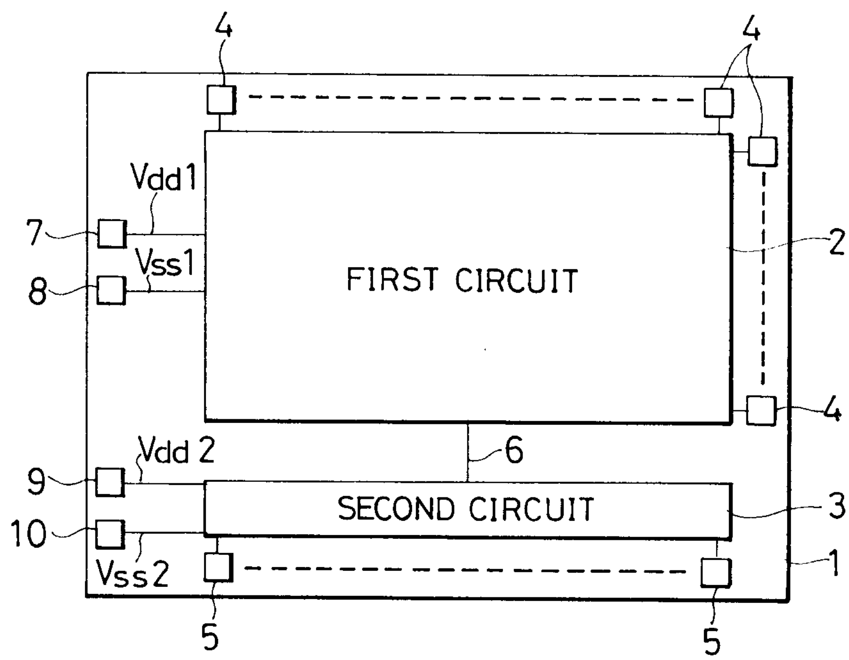
4
4
Vdd1
7
Vss1
FIRST CIRCUIT
2
8
4
6
Vdd 2
9
SECOND CIRCUIT
3
10
Vss2
1
5
5

FIG.1(b)

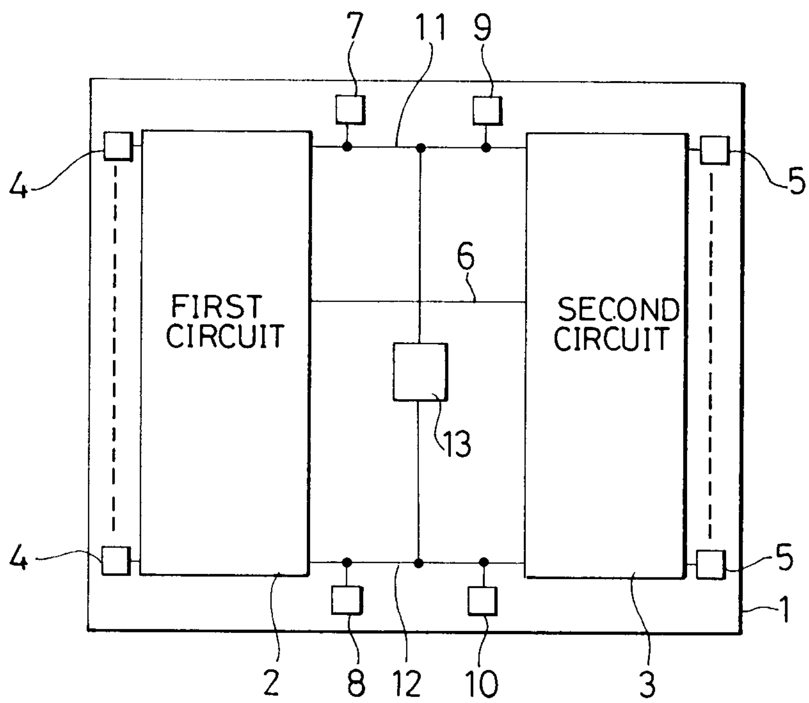
7
11
9
4
5
6
FIRST CIRCUIT
SECOND CIRCUIT
13
4
5
1
2
8
12
10
3

FIG.2(b)

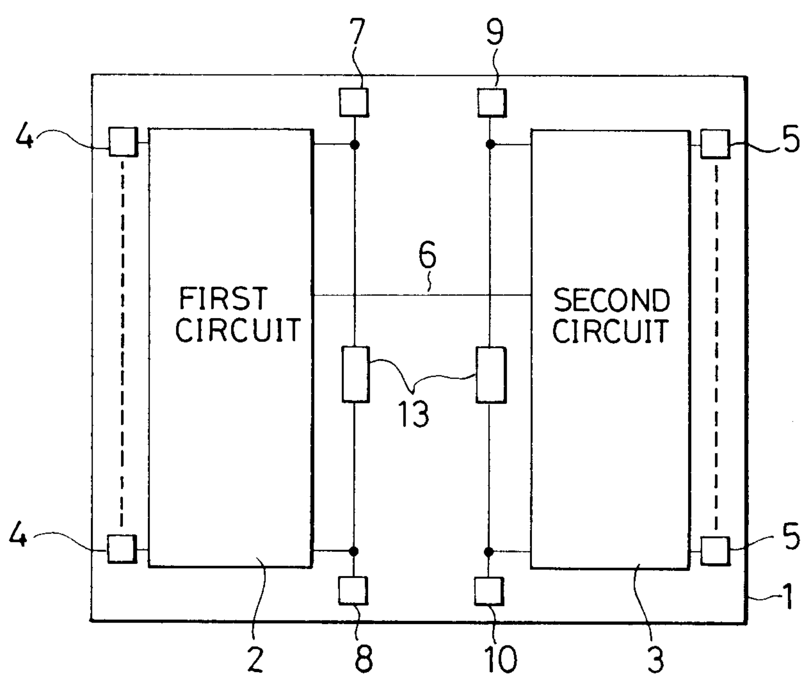
7
9
4
5
6
FIRST CIRCUIT
SECOND CIRCUIT
13
4
5
1
2
8
10
3

FIG.3

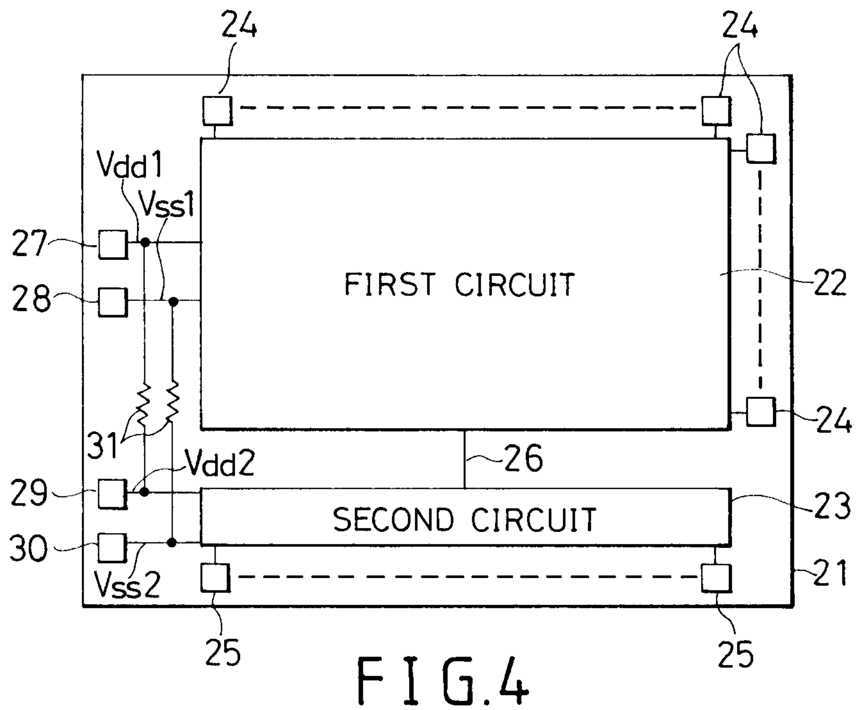
24
24
Vdd1
Vss1
27
28
FIRST CIRCUIT
22
24
31
Vdd2
26
29
SECOND CIRCUIT
23
30
Vss2
21
25
25

FIG.4

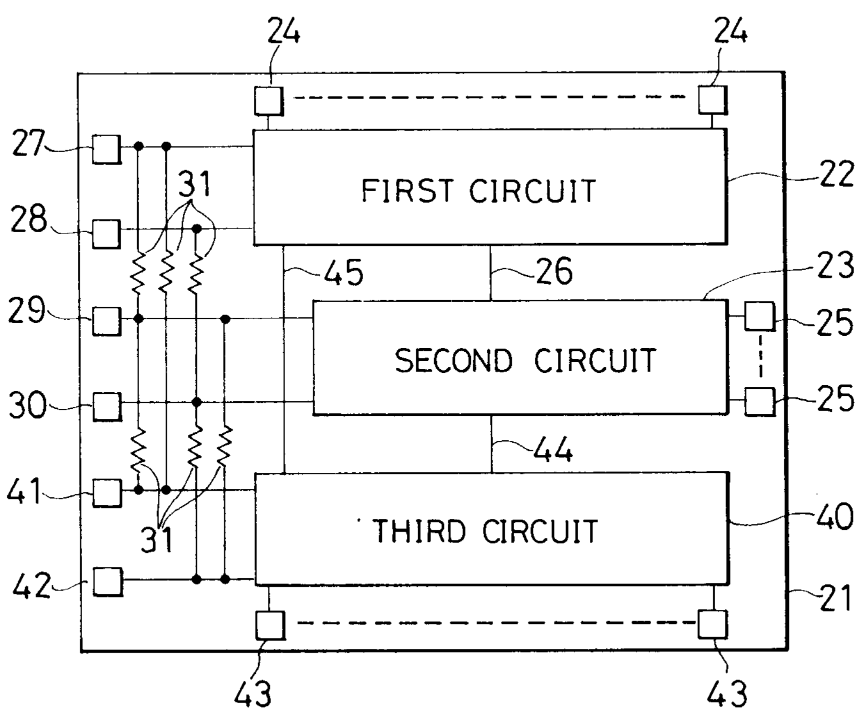
24
24
27
FIRST CIRCUIT
22
31
28
45
26
23
29
SECOND CIRCUIT
25
30
25
44
41
THIRD CIRCUIT
40
31
42
21
43
43

# FIG.5

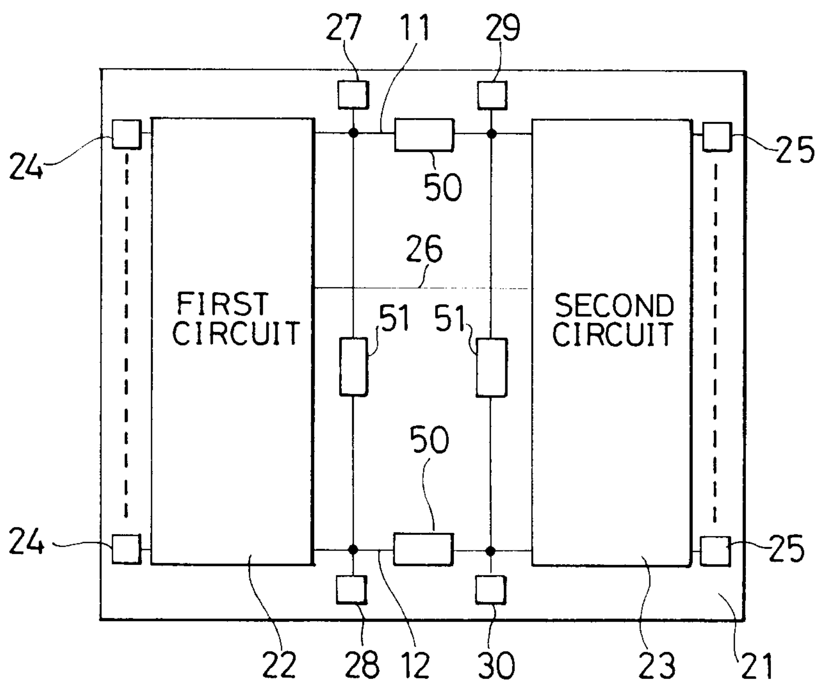
27
11
29
24
25
50
26
FIRST CIRCUIT
SECOND CIRCUIT
51
51
50
24
25
22
28
12
30
23
21

# FIG.6

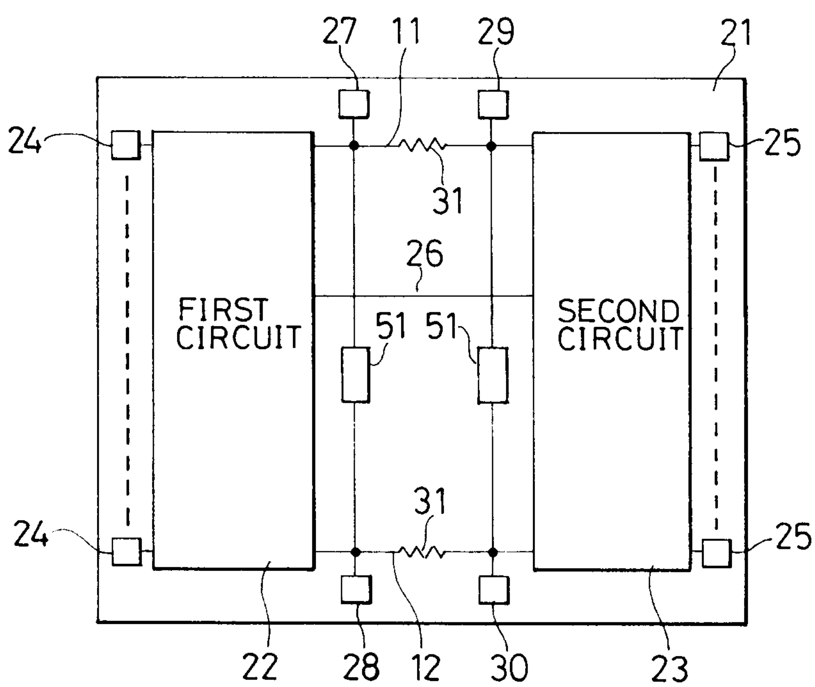
27
11
29
21
24
25
31
26
FIRST CIRCUIT
SECOND CIRCUIT
51
51
31
24
25
22
28
12
30
23

FIG.7

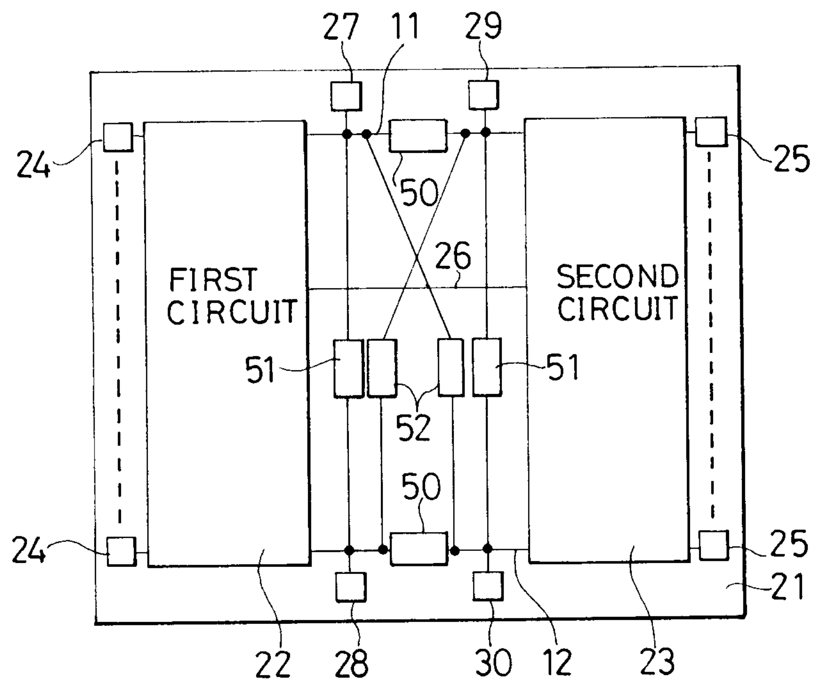
27
11
29
24
25
50
26
FIRST
CIRCUIT
SECOND
CIRCUIT
51
51
52
50
24
25
21
22
28
30
12
23

FIG.8

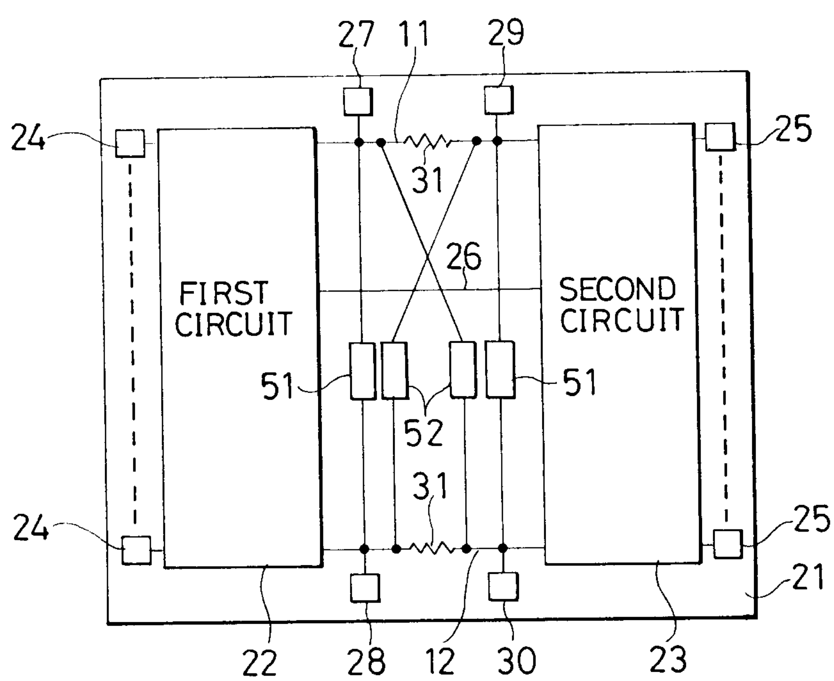
27
11
29
24
25
31
26
FIRST
CIRCUIT
SECOND
CIRCUIT
51
51
52
31
24
25
21
22
28
12
30
23

FIG.9

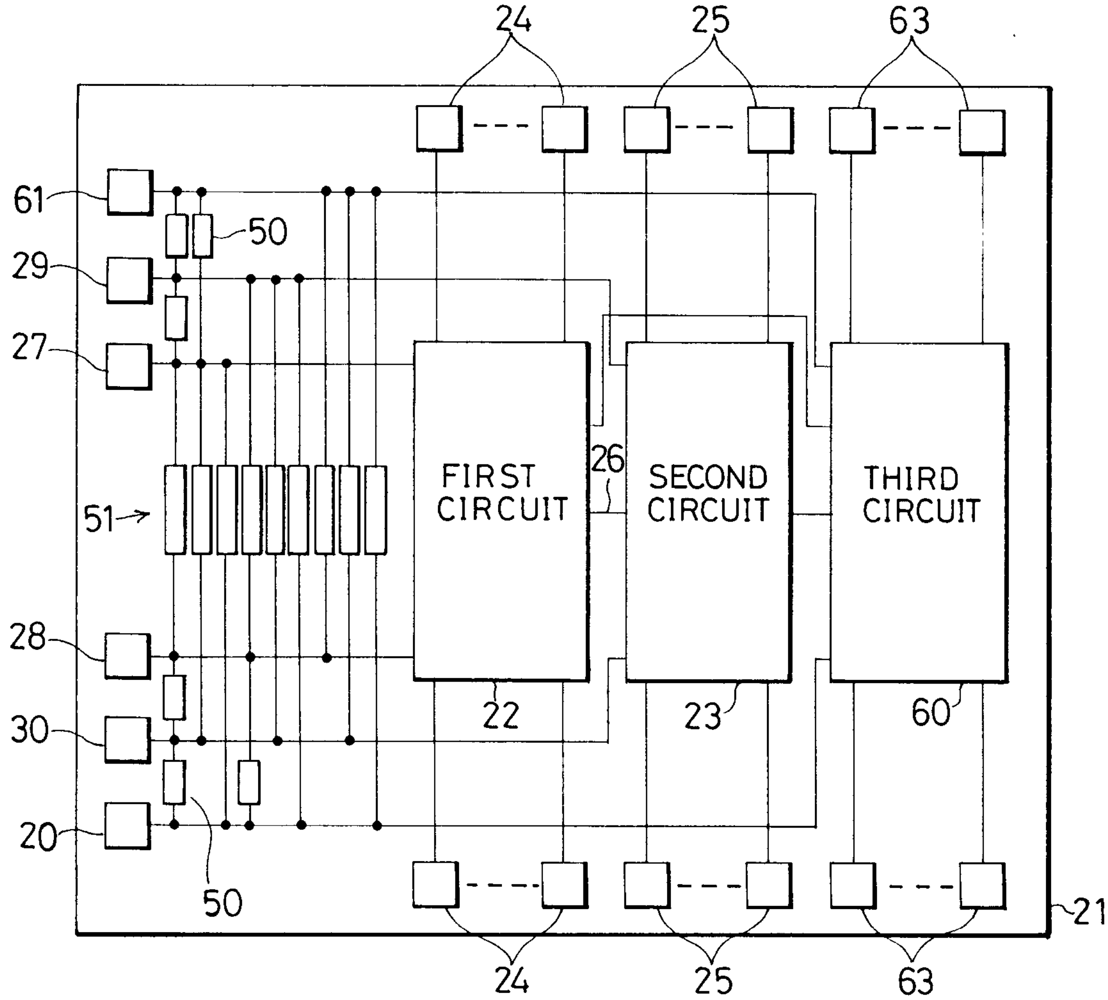
24
25
63
61
50
29
27
51
FIRST CIRCUIT
26
SECOND CIRCUIT
THIRD CIRCUIT
28
22
23
60
30
20
50
24
25
63
21

FIG.10

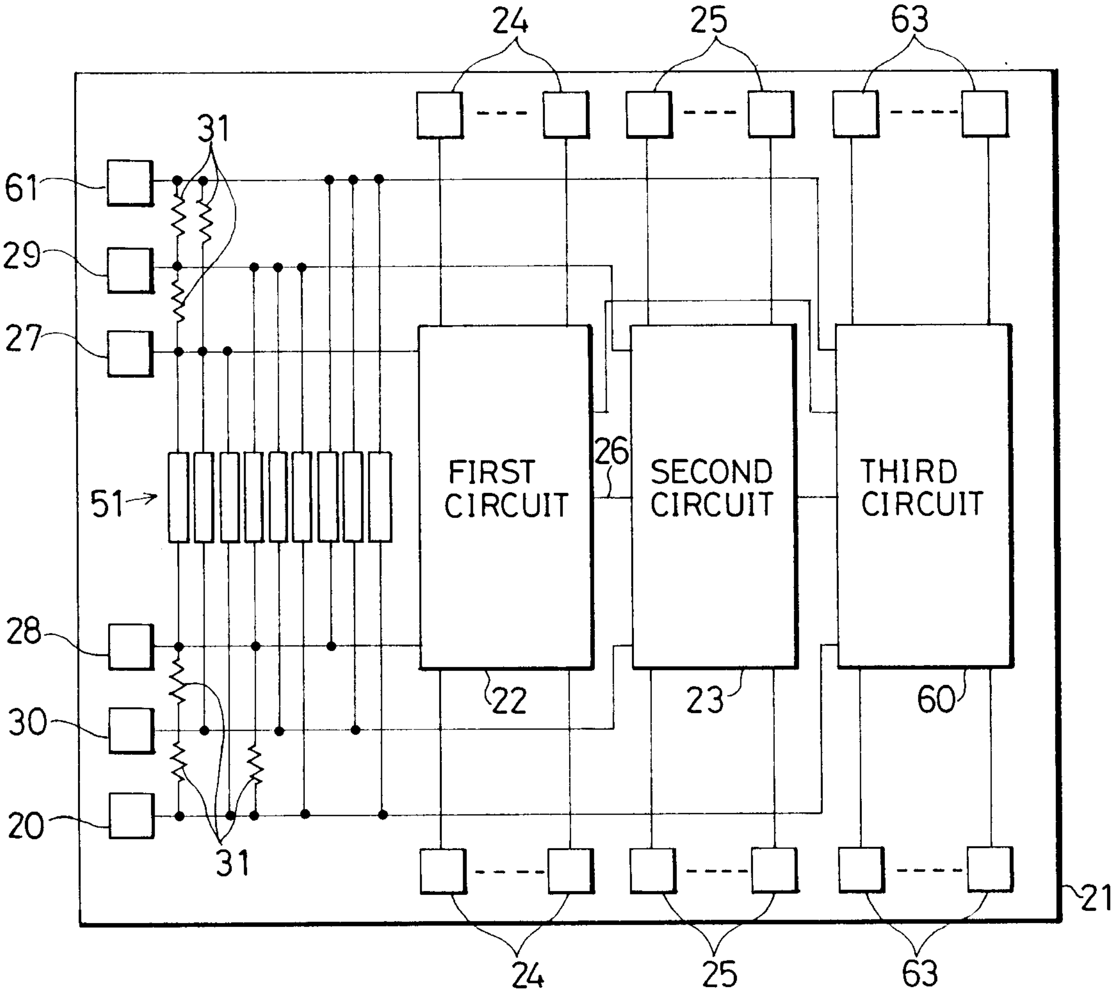
24
25
63
31
61
29
27
51
FIRST CIRCUIT
26
SECOND CIRCUIT
THIRD CIRCUIT
28
30
20
22
23
60
31
21
24
25
63